(19) **Europäisches Patentamt**

**European Patent Office**

**Office européen des brevets**

(11) **EP 0 889 586 B1**

(12) **EUROPÄISCHE PATENTSCHRIFT**

(45) Veröffentlichungstag und Bekanntmachung des Hinweises auf die Patenterteilung:
**01.10.2003 Patentblatt 2003/40**

(51) Int Cl.$^7$: **H03H 17/06**

(21) Anmeldenummer: **97110912.9**

(22) Anmeldetag: **02.07.1997**

(54) **Einrichtung zur Reduktion der Datenrate**

Device for reducing data rate

Dispositif pour la réduction du flot de données

(84) Benannte Vertragsstaaten:
**DE FR GB IT NL**

(43) Veröffentlichungstag der Anmeldung:
**07.01.1999 Patentblatt 1999/01**

(73) Patentinhaber: **Micronas Semiconductor Holding AG**
**8005 Zürich (CH)**

(72) Erfinder: **Menkhoff, Andreas, Dr.**
**81927 München (DE)**

(74) Vertreter: **Sauer, Wolfgang**
**MICRONAS INTERMETALL GmbH,**
**Patentabteilung,**
**Hans-Bunte-Strasse 19**
**79108 Freiburg (DE)**

(56) Entgegenhaltungen:
**EP-A- 0 176 946          EP-A- 0 320 517**

- **SHUNI CHU ET AL: "Multirate filter designs using comb filters" IEEE TRANSACTIONS ON CIRCUITS AND SYSTEMS., Bd. 31, Nr. 11, November 1984, NEW YORK US, Seiten 913-924, XP002049419**

**Beschreibung**

Die Erfindung betrifft eine Einrichtung zur Reduktion der Datenrate einer Datenfolge, die insbesondere dazu dient, die Abtastrate von digitalisierten Signalen um einen nichtganzzahligen Faktor zu reduzieren. Derartige Einrichtungen sind beispielsweise dort erforderlich, wo vorgegebenen Datenfolgen an unterschiedliche Verarbeitungstakte angepaßt werden sollen, die eigentlichen Signalinhalte aber nicht verändert werden sollen. Derartige Anwendungen betreffen insbesondere überabgetastete Audiosignale, aber auch Video- und andere Signale, deren Abtasttakt um einen nichtganzzahligen Faktor für die weitere Verarbeitung oder Speicherung zu reduzieren ist. Die Erfindung kann ferner auch dort angewendet werden, wo der Signalinhalt verändert werden soll, beispielsweise ermöglicht die Erfindung bei Videosignalen eine verkleinerte Bildwiedergabe, indem durch die Reduktion der Datenanzahl jedoch unter Beibehaltung der Datenrate ein verkleinertes Bild in einem Bildfenster eines Fernseh- oder Computer-Bildschirms darstellbar ist. Das verbleibende Bild kann beispielsweise ein Standbild, ein laufendes Fernsehbild oder eine computergesteuerte Animation sein.

Im allgemeinen werden für derartige Anwendungen relativ aufwendige Interpolationsfilter mit transversalen und/oder rekursiven Filterstufen verwendet, um eine nichtganzzahlige Reduktion der Datenrate zu ermöglichen. Eine Beschreibung derartiger AbtastratenAbtastraten-Umsetzungseinrichtungen findet sich beispielsweise in "Transactions on Acoustics, Speech, and Signal Processing", Band ASSP-32, Nr. 3, Juni 1984, Seiten 577 bis 591 unter dem Titel: »Digital Methods for Conversion Between Arbitrary Sampling Frequencies" von Tor A. Ramstad.

Die Einrichtungen zur Reduktion der Datenrate sind relativ einfach zu realisieren, wenn sich die alte und neue Datenrate in aufeinanderfolgenden gleichen Abtastintervallen nur um einen Abtastwert unterscheiden. Beispielsweise wenn aus drei aufeinanderfolgenen Abtastwerten zwei neue Abtastwerte gebildet werden sollen. Dies entspricht einem Datenrate-Reduktionsfaktor r = 1,5. Oder wenn aus zehn alten Abtastwerten neun neue Abtastwerte zu interpolieren sind, dies entspricht einem DatenDaten-Reduktionsfaktor r = 10/9. Für diese speziellen Datenrate-Reduktionsfaktoren sind sehr einfache Filtereinrichtungen bekannt, bei denen in regelmäßigen Intervallen jeweils ein Abtastwert weggelassen wird und die verbleibende Datenfolge mit einem digitalen Tiefpaßfilter geglättet wird.

Besonders einfache Schaltungen und Verfahren sind bekannt, wenn die Reduktion der Datenrate um einen ganzzahligen Reduktionsfaktor r erfolgt. Dabei werden jeweils mehrere Datenwerte, die ein Datenfenster bilden, zu einem neuen Datenwert zusammengezogen und die Folge aus den neuen Datenwerten bildet dann die gewünschte neue Datenfolge. In der digitalen Signalverarbeitung wird diese Art der Abtastratenreduktion auch als Dezimierung bezeichnet. Die Datenwerte im Datenfenster können dabei entsprechend dem gewählten Interpolationsverfahren mit einer zugehörigen Gewichtungsfunktion modifiziert werden. Aufgrund des einfachsten Gewichtungsfalles, bei dem die Daten innerhalb des Datenfensters nicht gewichtet werden, werden diese Schaltungen auch als "Kammfilter" bezeichnet. Eine Beschreibung hierzu findet sich in »IEEE Transactions on Circuits and Systems", Band CAS-31, Nr. 11, November 1984, Seiten 913 bis 924 unter dem Titel: "Multirate Filter Designs Using Comb Filters" von Shuni Chu und C. Sidney Burrus.

Derartige Kammfilter umfassen in der Regel mindestens einen Akkumulator, einen Dezimierungsschalter, der nach der vorgegebenen Zahl von Abtastwerten geschlossen wird und einen Differenzierer. Jeder Akkumulator und Differenzierer enthält dabei eine Verzögerungsstufe und einen Addierer bzw. Subtrahierer. Die Addierer und Differenzierer bilden zusammen ein mitlaufendes Datenfenster zur Bildung des interpolierten Abtastwertes. Der einzelne Akkumulator bewirkt keine Gewichtung. Durch zwei oder mehr in Reihe geschaltete Akkumulatoren und eine gleichgroße Anzahl von in Reihe geschalteten Differenzierern können jedoch auch Gewichtungsfunktionen höherer Ordnung gebildet werden. Wird der letzte Akkumulator als rücksetzbarer Akkumulator ausgebildet, der zusammen mit den Dezimierungsschalter zurückgesetzt wird, dann reduziert sich die Anzahl der erforderlichen Differenzierer um einen Differenzierer. Die Karninfilterstruktur hat auch den Vorteil, daß der hohe Verarbeitungtakt nur für die Akkumulatoren erforderlich ist, während die Differenzierer mit dem niederen Takt des Dezimierungsschalters arbeiten.

Es ist Aufgabe der Erfindung, eine einfache Schaltung zur Reduktion der Datenrate um einen nichtganzzahligen Reduktionsfaktor, der sich als eine rationale Zahl darstellen läßt, anzugeben.

Die Lösung der Aufgabe erfolgt entsprechend den Merkmalen des Anspruchs 1 durch:

- eine umschaltbare Filtereinrichtung, die in einem ersten Schaltzustand erste Ausgangswerte nach a Abtastschritten und in einem zweiten Schaltzustand zweite Ausgangswerte nach a + 1 Abtastschritten liefert und zur Bildung gefilterter Datenwerte ein mitlaufendes Datenfenster aufweist, wobei

- dem mitlaufenden Datenfenster mindestens zwei unterschiedliche Fenstergrößen zugeordnet sind, deren Auswahl von der Folge der ersten und zweiten Ausgangswerte abhängig ist, und

- die eine Fenstergröße b Abtastwerte und die andere Fenstergröße c Abtastwerte mit $b \geq a$ und $c \geq a+1$ umfaßt, und

- eine mit der umschaltbaren Filtereinrichtung gekoppelten Steuereinrichtung, die mittels des ersten und zweiten Schaltzustandes innerhalb gleichlanger Abschnitte der Datenfolge die Bildung von n ersten und m zweiten Ausgangswerten sowie die Auswahl der zugehörigen Datenfenster bewirkt, dabei ist die Anzahl der n ersten und m zweiten Ausgangswerte durch eine Bemessungsregel r = a + m/(n + m) bestimmt, wobei r ein Datenrate-Reduktionsfaktor ist.

Ein vorteilhaftes Ausführungsbeispiel der Erfindung ergibt sich, wenn als Grundstruktur für die umschaltbare Filtereinrichtung das bereits beschriebene Kammfilter, das eine einfache oder höhere Ordnung aufweisen kann, in Serienschaltung verwendet wird. Durch die Schließung des Dezimierungsschalters nach a oder a+1 Abtastwerten ergibt sich automatisch die richtige Fenstergröße des mitlaufenden Datenfensters. Entsprechend der Ordnung p des Kammfilers ist die Anzahl der Akkumulatoren und Differenzierer vorzugeben, wobei die Anzahl der Differenzierer um Eins reduziert werden kann, wenn der letzte Akkumulator rücksetzbar ist. Die Realisierung der umschaltbaren Filtereinrichtung kann jedoch auch über andere Filterstrukturen oder rein über eine Programmsteuerung erfolgen, indem die vorgesehenen digitalen Übertragungsfunktionen durch geeignete Programme realisiert sind. Da in der digitalen Signalverarbeitung in der Regel normierte Signalbereiche verwendet werden, ist gegebenenfalls die umschaltbare Filtereinrichtung durch eine Amplituden-Normierungseinrichtung zu ergänzen, insbesondere wenn die Verstärkungen im ersten und zweiten Schaltzustand relativ unterschiedlich sind. In der neuen Datenfolge sind schließlich die ersten und zweiten Ausgangswerte möglichst gleichmäßig alternierend verteilt, so daß die interpolierten Abtastwerte zeitlich möglichst dicht bei den theoretischen Abtastwerten liegen. Bei Audiosignalen kann unter Umständen die unterschiedliche Amplituden-Normierung entfallen, weil das Ohr wegen des Tiefpaßverhaltens für kurzzeitige Signalspitzen nicht empfindlich ist und sie daher nicht hört.

Die Erfindung und weitere Vorteile werden nun anhand der Figuren der Zeichnung näher erläutert:

Fig.1 zeigt als Blockschaltbild ein erstes Ausführungsbeispiel,
Fig. 2 zeigt als Blockschaltbild ein zweites Ausführungsbeispiel,
Fig. 3 zeigte eine umschaltbare Filtereinrichtung höherer Ordnung und
Fig. 4 zeigt im Zeitdiagramm ein einfaches Beispiel zur Reduktion der Datenrate.

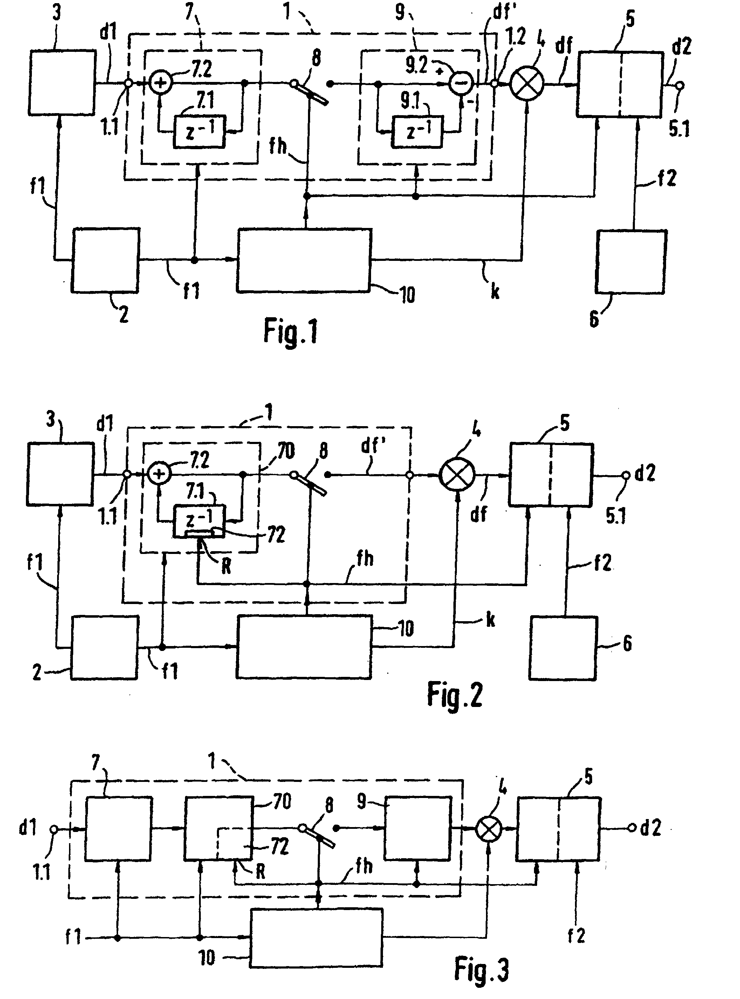

In Fig.1 ist im Blockschaltbild als erstes Ausführungsbeispiel der Erfindung eine Einrichtung zur Reduktion der Datenrate einer Datenfolge d1 dargestellt, die mittels einer umschaltbaren Filtereinrichtung 1 in eine Ausgangs-Datenfolge d2 umgesetzt wird. Die Datenrate der Eingangs-Datenfolge d1 entspricht einem ersten Takt f1, der einer ersten Taktquelle 2 entstammt und eine Datenquelle 3 steuert. Der erste Takt f1 kann auch einem Systemtakt entsprechen oder durch die Datenrate der Datenfolge d1 vorgegeben sein, aus der er mittels einer Phasenverriegelungsschleife (=PLL) wieder zurückgewonnen werden kann.

Die umschaltbare Filtereinrichtung 1 ist über den Filtereingang 1.1 an die Datenquelle 3 angeschlossen und gibt am Ausgang 1.2 erste gefilterte Datenwerte df' ab, die gegebenenfalls mit einer Amplituden-Normierungseinrichtung 4 in der Verstärkung noch angepaßt werden und dann die eigentlichen gefilterten Datenwerte df bilden. Die Amplitudenanpassung erfolgt durch einen dem Multiplizierer 4 zugeführten Abschwächungsfaktor k, der die Werte k-1 lb und k=1/c hat. Die gefilterten Datenwerte df gelangen schließlich auf einen Pufferspeicher 5, dessen Ausgangsstufe von einer zweiten Taktquelle 6 mit einem zweiten Takt f2 gesteuert ist. Dabei entspricht der zweite Takt f2 der gewünschten Datenrate der Ausgangsdatenfolge d2, die an einem Pufferausgang 5.1 abgreifbar ist, der damit auch Ausgang der gesamten Datenrate-Reduktionseinrichtung ist.

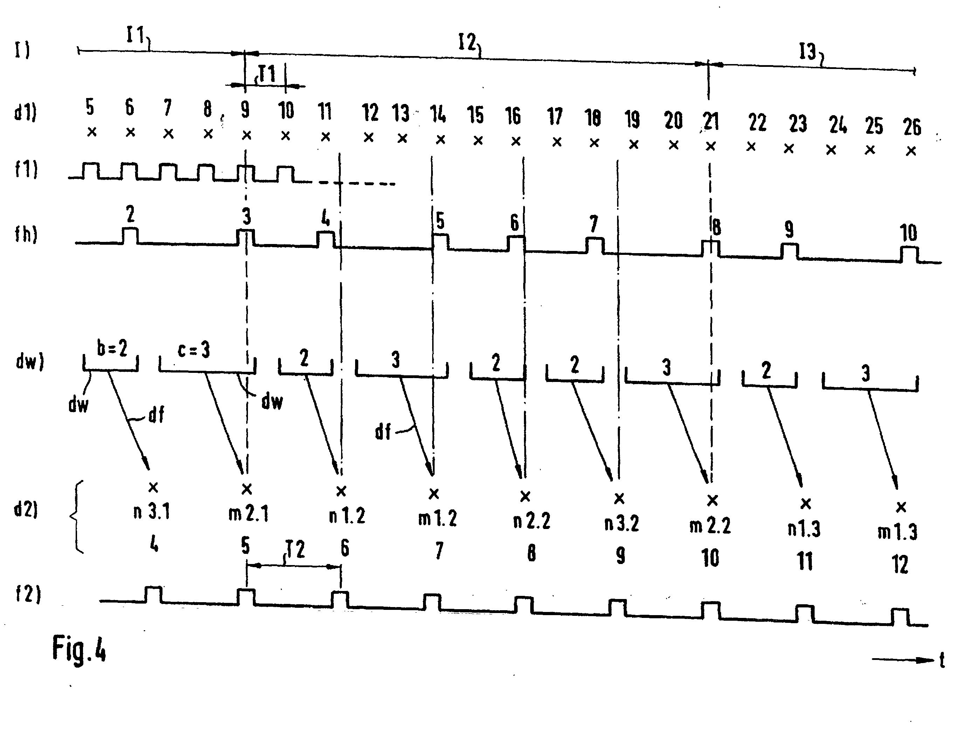

Die umschaltbare Filtereinrichtung 1 enthält in Signalflußrichtung einen Akkumulator 7, einen Dezimierungsschalter 8 und einen Differenzierer 9. Den Akkumulator 7 bildet eine Ringschaltung aus einem Addierer 7.2 und einer Verzögerungseinrichtung 7.1, wobei der Ausgang des Addierers 7.2 mit dem Eingang des Dezimierungsschalter 8 verbunden ist, dessen Steuereingang von einem Hilfstakt fh gesteuert ist, der über eine Steuereinrichtung 10 mit der ersten Taktquelle 2 oder mit dem ersten Takt f1 verkoppelt ist. Der Hilfstakt fh ist dabei eine nichtäquidistante Taktfolge, vgl. in Fig. 4 den Impulszug fh, bei der jeweils nach a oder a + 1 Taktschritten T1 des ersten Taktes f1 ein Impuls ausgelöst wird. Mit jedem Impuls des Hilfstaktes fh wird der Dezimierungsschalter 8 geschlossen, so daß der Inhalt des Akkumulators 7 über den Signalausgang des Dezimierungsschalters 8 dem Differenzierer 9 zugeführt wird. Der Differenzierer besteht aus einer Verzögerungseinrichtung 9.1 und einem Subtrahierer 9.2, dessen Minuend-Eingang mit dem Eingang der Verzögerungseinrichtung 9.1 und dem Signalausgang des Dezimierungsschalters 8 verbunden ist. Der Ausgang der Verzögerungseinrichtung 9.1 ist dem Subtrahend-Eingang zugeführt, so daß der jeweilige Inhalt der Verzögerungseinrichtung 9.1 vom durchgeschalteten Akkumulatorinhalt abgezogen wird. Dieser Subtraktionsvorgang erfolgt immer dann, wenn der Hilfstakt fh den Dezimierungsschalter 8 schließt.

Der Wert des gefilterten Datenwerts df' am Ausgang 1.2 der Filtereinrichtung 1 ist somit der Summenwert der Eingangsdatenfolge d1 in einem mitlaufenden Datenfenster dw (vgl. Fig. 4), dessert l.änge durch das zugehörige Taktintervall des Hilfstaktes fh gebildet wird. Springt beispielsweise der Hilfstakt fh alternierend zwischen zwei und drei Abtastwerten des ersten Taktes f1 hin- und her, dann findet $_e$ine Reduktion der Datenrate um den Faktor r = 2,5 staff. Ist der Hilfstakt th zeitlichen Mittel aus drei ersten Datenfenstern b mit jeweils zwei Abtastwerten und zwei zweiten Datenfenstern c mit jeweils drei Abtastwerten gebildet, dann entspricht dies einer Reduktion der Datenrate um den Faktor r = 2,4. Es lassen sich auf diese Weise nicht nur diese einfachen Abtastratenverhältnisse reduzieren sondern über ganzzahlige Zwischenumsetzungen auch wesentlich kompliziertere, beispielsweise die Anpassung eines Audiosignals, das mit einer Datenrate von 18,43 MHz empfangen wird an einen Systemtakt von 20,25 MHz, wobei die resultierende, relativ niederfrequente Datenrate letztendlich im Bereich von 32 kHz liegt.

Die Steuereinrichtung 10 läßt sich beispielsweise durch einen rücksetzbaren Zähler realisieren, der vom ersten Takt f1 getaktet ist und der im Beispiel des Reduktionstaktors r=2.4 (vergl. Fig. 4) immer bei der Zahl 12 zurückgesetzt wird. Die vom Eingangstakt f1 abhängigen Zählwerte 0,5 und 7 lösen den ersten Schaltzustand und die Zählwerte 2 und 9 den zweiten Schaltzustand aus. Die auslösenden Zählwerte einschließlich des Rücksetzwertes können in einer Tabelle gespeichert sein, die über den Reduktionsfaktor r als Adresse abrufbar ist. Über einen Bus kann der Inhalt eines entsprechenden SchreibSchreib/Lespeichers beliebig vom Anwender oder von einer Rechenschaltung verändert werden, so daß die gewünschten Reduktionsfaktoren r realisiert werden können.

In Fig. 2 ist ein zweites Ausführungsbeispiel der Erfindung dargestellt, das bis auf die umschaltbare Filtereinrichtung 1 identisch zum Blockschaltbild von Fig.1 ist. Dabei sind gleiche Funktionseinheiten mit gleichen Bezugszeichen versehen, so daß sich eine nochmalige Erörterung erübrigt. Die Unterschiede in der umschaltbaren Filterein-tung 1 bestehen darin, daß der einzige Akkumulator 70 als rücksetzbarer Akkumulator ausgebildet ist, indem die Verzögerungseinrichtung 71 mittels einer Rücksetzeinrichtung 72 auf den Wert Null gesetzt werden kann, wenn ein Rücksetzsignal am Rücksetzeingang R angelegt wird. Als Rücksetzsignal dient der Hilfstakt fh, der auch den Dezimierungsschalter 8 steuert. Die Rücksetzung des Akkumulators 70 entspricht der Wirkung des Differenzierers 9 von Fig. 1,so daß dieser in Fig.2 2 entfallen kann. Die Schaltung vereinfacht sich dadurch. Das mitlaufende Datenfenster wird somit automatisch durch den rücksetzbaren Akkumulator 70 definiert.

Im Blockschaltbild von Fig.3 3 ist als umschaltbare Filtereinrichtung 1 ein Kammfilter zweiter Ordnung dargestellt, das in Signalflußrichtung einen ersten Akkumulator 7 wie aus Fig. 1, einen rücksetzbaren Akkumulator 70 wie aus Fig. 2, einen Dezimierungsschalter und einen Differenzierer 9 wie in Fig. 1 enthält. Eine funktionsgleiche aber nicht dargestellte Variante umfaßt zwei (p = 2) Akkumulatoren, einen Dezimierungsschalter und zwei (p = 2) Differenzierer. Durch die Rücksetzeinrichtung 72 im letzten Akkumulator 70 wird der zweite Differenzierer eingespart, so daß die umschaltbare Filtereinrichtung 1 von Fig. 3 nur mit einem Differenzierer 9 auskommt. Das Kammfilter zweiten Grades hat durch die hintereinandergeschalteten Akkumulatoren 7,70 ein mitlaufendes Datenfenster, das in beiden Schaltzuständen größer ist als die Intervalle des Hilfstaktes fh. Durch die doppelte Integation ist die Gewichtung der einzelnen Abtastwerte nicht mehr gleich sondern unterschiedlich. Ferner liegen nun drei unterschiedliche Fenstergrößen des mitlaufenden Datenfensters vor, weil eines speziell dem Übergangszustand zugerechnet ist, also dem Übergang vom ersten auf den zweiten Schaltzustand und umgekehrt.

An einem Zahlenbeispiel mit dem Kammfilter zweiter Ordnung von Fig. 3, das zwischen den Abtastraten 2 und 3 umgeschaltet wird, soll dies anhand der komplexen Übertragungsfunktion H(z) verdeutlicht werden. Wird in stetiger Folge jeweils nach zwei Abtastwerten ein neuer Ausgangwert gebildet wird gilt folgende Übertragungsfunktion:

$$H(z) = ((1- z^{-2}) / (1 - z^{-1}))^2 = 1 + 2z^{-1} + z^{-2} \tag{1}$$

Das mitlaufende Datenfenster dw umfaßt drei Werte der Datenfenster d1, und die umschaltbare Ritereinrichtung 1 befindet sich im ersten Schaltzustand.

Werden die Abtastintervalle von zwei auf drei oder von drei auf zwei Taktperioden T1 umgeschaltet so realisiert die Schaltung für den jeweiligen Abtastwert die Übertragungsfunktion:

$$H(z)=(1-z^{-2})\times(1-z^{-3})/(1-z^{-1})^2 = 1+ 2z^{-1} + 2z^{-2} + z^{-3} \tag{2}$$

Das mitlaufende Datenfenster umfaßt vier Abtastwerte. Die umschaltbare Filtereinrichtung 1 ist hierbei je nach dem Endzustand des Wechsels dem zweiten oder dem ersten Schaltzustand zuzurechnen.

Wird in stetiger Folge jeweils nach drei Abtastwerten eine neuer Ausgangswert gebildet, so realisiert die Schaltung die Übertragungsfunktion:

$$H(z)=((1-z^{-3})/(1-z^{-1}))^2 = 1+2z-1+3z^{-2}+2z^{-3}+z^{-4} \tag{3}$$

Hierbei umfaßt das mitlaufende Datenfenster fünf Abtastwerte und die umschaltbare Filtereinlichtung befindet sich im zweiten Schaltzustand.

In der Regel wird nur zwischen den Übertragungsfunktionen (1) und (2) oder den Übertragungsfunktionen (2) und (3) umgeschaltet, weil die Folge der ersten und zweiten Ausgangswerte möglichst alternierend sein soll. Die Übertragungsfunktionen (1) und (2) sind nur dann anzuwenden, wenn der vorausgehende Schaltzustand identisch war. Bei einem Reduktionsfaktor r=2,9 kämen beispielsweise die Übertragungsfunktionen (2) und insbesondere (3) in Betracht, weil entsprechend der Bemessungsregel $r = a + m/(n+m)$ auf neun zweite Abtastwerte dm mit drei Abtastschritten nur ein erster Abtastwert dn mit zwei Abtastschritten folgt. Eine bessere Alternierung ist hier nicht möglich. Noch mehr gilt dies, wenn das Abtastraten verhältnis gegenüber den beiden Abtastintervallen a und a+1 noch einseitiger liegt, beispielsweise bei einem Abtastraten-Reduktionsfaktor r = 2,99.

Die einzelnen Übertragungsfunktionen (1), (2), (3) zeigen, daß zur Bildung der gefilterten Datenwerte df eine unterschiedliche Gewichtung der Abtastwerte vorliegt. Aus dem Beispiel ist ferner ersichtlich, daß die Verstärkung im ersten Schaltzustand den Wert 4, im Wechselzustand den Wert 6 und im zweiten Schältzustand den Wert 9 hat. Mittels der AmplitudenAmplituden-Normierungseinrichtung 4 und dem Abschwächungsfaktor k können die unterschiedlichen Verstärkungen für die gefilterten Datenwerte df'ausgeglichen werden.

Aus dem Beispiel mit dem Kammfilter zweiten Grades kann auch die rein programmgesteuerte Realisierung leicht erkannt werden, indem die einzelnen Abtastwerte zunächst zwischengespeichert und mit der entsprechenden Gewichtung mittels eines vorhandenen Rechenwerkes in einem Prozessor addiert werden. Die Nachbildung mit Akkumulatoren, Dezimierungsschaltern und Differenzierern ist hierfür nicht erforderlich.

In Fig.4 4 ist zur Verdeutlichung der Erfindung ein Zeitdiagramm dargestellt, das anschaulich die Funktion der Schaltung nach Fig. 1 oder Fig. 2 bei einem Datenrate-$R_e$duktionsfaktor r = 2,4 zeigt. Von einer Eingangsdatenfolge d1 sind schematisch die Abtastzeitpunkte als liegende Kreuze dargestellt, die von 5 bis 26 durchnummeriert sind. Diese Datenfolge d1 ist in gleichlange Zeitabschnitte I bzw. I1, I2,I3 eingeteilt, die jeweils 12 Abtastintervalle T1 umfassen, die durch den ersten Takt f1 zeitlich definiert sind. In der Darstellung ist der erste und dritte Abschnitt I1, I3 unvollständig, der vollständige zweite Abschnitt I2 reicht vom Abtastwert 9 bis zum Abtastwert 21. Für den gewünschten Abtastratenreduktionsfaktor r = 2,4 müssen die zwölf Taktperioden T1 umfassenden Abschnitte I1,I2, I3 jeweils in drei Unterabschnitte mit zwei Taktperioden T1 und zwei Unterabschnitte mit drei Taktperioden T1 unterteilt werden. Den einzelnen Abschnitten entspricht dabei ein mitlaufendes Datenfenster dw, das entweder b = 2 oder c = 3 Abtastwerte zur Mittelwertbildung umfaßt. Das mitlaufende Datenfenster dw mit b Abtastwerten entspricht dabei dem ersten Schaltzustand und das mitlaufende Datenfenster dw mit c Abtastwerten entspricht dabei dem zweiten Schaltzustand der umschaltbaren Filtereinrichtung 1.

Im Zeitdiagramm von Fig.4 4 ist auch zu sehen, daß der nicht äquidistante Hilfstakt fh und das mitlaufende Datenfenster dw zeitlich mit der Eingangsdatenfolge d1 und damit mit dem ersten Takt f1 verkoppelt sind.

Aus der Mittelwertbildung der Abtastwerte im jeweiligen Datenfenster dw werden die gefilterten Datenwerte df gebildet, die im Pufferspeicher 5 zwischengespeichert werden, bis sie vom zweiten Takt f2, dem Ausgangstakt, abgerufen werden und die n ersten oder m zweiten Ausgangswerte der Datenfolge d2 bilden. Beispielsweise bilden die Abtastwerte 5 und 6 der Folge d1 den Ausgangswert n3.1 der Datenfolge d2. Die letzten Abtastwerte 7, 8, 9 im Intervall I1 bilden den Ausgangswert m2.1, der als letzer Wert noch dem Intervall I1 zuzurechnen ist. Der erste Ausgangswert, der dem zweiten Intervall I2 zuzurechnen ist, ist der Ausgangswert n1.2, der aus den Abtastwerten 10 und 11 der Datenfolge d1 gebildet wird.

Je nach der Länge des zugehörigen Datenfensters wird bei der Datenfolge d2 zwischen ersten Ausgangswerten dn (in Fig.4 mit n... bezeichnet) und zweiten Ausgangswerten dm (in Fig. 4 mit m... bezeichnet) unterschieden. Die von n3.1 bis m1.3 reichende Datenfolge d2 ist in Fig. 4 von 4 bis 12 durchnummeriert. Da die Datenfolge d2 mit dem Ausgangstakt f2 zeitlich verkoppelt ist, folgen die neuen Abtastwerte n3.1 bis m1.3 äquidistant aufeinander, wobei die Datenrate durch die Periode T2 bestimmt ist.

Nach jeweils 12 Abtastschritten T1 ergibt sich eine Koinzidenz zwischen dem ersten und zweiten Takt f1, f2. Dies ist jedoch nicht zwingend, denn in der Realität können Phasendifferenzen zwischen dem ersten und zweiten Takt f1, f2 durch den Pufferspeicher 5 ausgeglichen werden. Es ist sogar möglich, daß ein ganzer Block von gefilterten Datenwerten df in einem großen Pufferspeicher, beispielsweise einem FIFO-Speicher (FIFO = First-In-First-Out), zwischengespeichert wird und dann burstweise mit einer ganz anderen Frequenz ausgelesen wird.

**Patentansprüche**

1. Einrichtung zur Reduktion der Datenrate einer Datenfolge (d1) mit

- einer umschaltbaren Filtereinrichtung (1), die in einem ersten Schaltzustand erste Ausgangswerte nach a Abtastschritten und in einem zweiten Schaltzustand zweite Ausgangswerte nach a + Abtastschritten liefert und zur Bildung gefilterter Datenwerte (df') ein mitlaufendes Datenfenster (dw) aufweist, wobei

- dem mitlaufenden Datenfenster (dw) mindestens zwei unterschiedliche Fenstergrößen zugeordnet sind, deren Auswahl von der Folge der ersten und zweiten Ausgangswerte abhängig ist, und

- die eine Fenstergröße b Abtastwerte und die andere c Abtastwerte mit $b \geq a$ und $c \geq a + 1$ umfaßt, und

- einer mit der umschaltbaren Filtereinrichtung (1) gekoppelten Steuereinrichtung (10), die mittels des ersten und zweiten Schaltzustandes innerhalb gleichlanger Abschnitte (I2) der Datenfolge (d1) die Bildung von n ersten, m zweiten Ausgangswerten und die Auswahl der zugehörigen Datenfenster (dw) bewirkt, dabei ist die Anzahl der n ersten und m zweiten Ausgangswerte durch eine Bemessungsregel $r = a + m/(n+ m)$ bestimmt, wobei r ein Datenrate-Reduktionsfaktor ist.

2. Einrichtung nach Anspruch 1, **dadurch gekennzeichnet, daß** die umschaltbare Filtereinrichtung (1) einem Kammfilter entspricht.

3. Einrichtung nach Anspruch 2, **dadurch gekennzeichnet, daß** das Kammfilter in Signalflußrichtung entweder

- p Akkumulatoren (7;7,70) einen Dezimierungsschalter (8) und p Differenzierer (9) oder

- p Akkumulatoren (7; 7,70) einen Dezimierungsschalter 8 und p-1 Differenzierer (9) enthält, wobei der in Signalflußrichtung liegende letzte Akkumulator (70) mittels einer Rücksetzeinrichtung (72) gleichzeitig mit der Schließung des Dezimierungsschalters 8 von der Steuereinrichtung 10 zurückgesetzt wird und $p \geq 1$ ist.

4. Einrichtung nach einem der Ansprüche 1 bis 3, **dadurch gekennzeichnet, daß** eine von der Steuereinrichtung (10) abhängige Amplituden-**Normierungseinrichtung** (4) die unterschiedliche Verstärkung der umschaltbaren Filtereinrichtung (1) kompensiert

5. Einrichtung nach einem der Ansprüche 1 bis 3, **dadurch gekennzeichnet, daß** der Amplituden-Normierungseinrichtung (4) unabhängig vom Schaltzustand ein fester Abschwächungsfaktor k zugeführt ist.

6. Einrichtung nach einem der Ansprüche 1 bis 5, **dadurch gekennzeichnet, daß** die Steuereinrichtung (10) die n ersten und m zweiten Ausgangswerte auf eine möglichst gleichmäßig alternierende Ausgangs-Datenfolge (d2) aufteilt.

**Claims**

1. A system for reducing the data rate of a data sequence (d1), comprising:

- a switchable filter device (1) which provides first output values after a sampling steps in a first state and second output values after a+1 sampling steps in a second state, and which has a tracking data window (dw) for forming filtered data values (df'),

- the tracking data window (dw) being assigned at least two different window sizes whose selection is dependent on the sequence of the first and second output values, and

- one of the window sizes comprising b sample values, and the other comprising c sample values, with $b \geq a$ and $c \geq a + 1$; and

- a control device (10), coupled to the switchable filter device (1), which, by means of the first and second states, causes the formation of n first and m second output values within equally long segments (I2) of the data sequence (d1) as well as the selection of the associated data windows, the number of n first and m second output values being determined by a rule $r = a + m/(n + m)$, where r is a data rate reduction factor.

2. A system as claimed in claim 1, **characterized in that** the switchable filter device (1) corresponds to a comb filter.

3. A system as claimed in claim 2, **characterized in that** the comb filter comprises, in the direction of signal flow, either

- p accumulators (7; 7, 70), a decimation switch (8), and p differentiators (9) or

- p accumulators (7; 7, 70), a decimation switch (8), and p-1 differentiators (9), with the last accumulator (70) being reset by means of a reset facility (72) simultaneously with the closure of the decimation switch (8) by the control device (10), and p ≥ 1.

4. A system as claimed in any one of claims 1 to 3, **characterized in that** an amplitude normalization device (4) controlled by the control device (10) compensates for differences in the gain of the switchable filter device (1).

5. A system as claimed in any one of claims 1 to 3, **characterized in that** regardless of the state of the switchable filter device (1), a fixed attenuation factor k is applied to the amplitude normalization device (4).

6. A system as claimed in any one of claims 1 to 5, **characterized in that** the control device (10) distributes the n first and m second output values to an output data sequence (d2) which alternates as uniformly as possible.


**Revendications**

1. Dispositif destiné à la réduction du débit de données d'une suite de données (d1) et comportant :

- un dispositif de filtrage commutable (1) qui fournit, dans un premier état de commutation, des premières valeurs de sortie après a étapes d'échantillonnage et, dans un deuxième état de commutation, des deuxièmes valeurs de sortie après a + 1 étapes d'échantillonnage et qui comporte, pour la formation de valeurs de données (df'), une fenêtre de données (dw), dispositif de réduction dans lequel
- on associe à la fenêtre de données (dw) courante au moins deux grandeurs de fenêtre différentes dont la sélection dépend de la séquence des premières et deuxièmes valeurs de sortie, et
- l'une des grandeurs de fenêtre comprend b valeurs d'échantillonnage et l'autre comprend c valeurs d'échantillonnage, b étant supérieur ou égal à a et c étant supérieur ou égal à a + 1, et
- un dispositif de commande (10) qui est couplé au dispositif de filtrage commutable (1) et qui, au moyen du premier et du deuxième états de commutation, cause, à l'intérieur de sections (12) de même longueur de la suite de données (d1), la formation de n premières et m deuxièmes valeurs de sortie et la sélection de la fenêtre de données (dw) correspondante, le nombre des n premières et des m deuxièmes valeurs de sortie étant déterminé par une règle de dimensionnement $r = a + m/(m + n)$ dans laquelle r est un facteur de réduction du débit de données.

2. Dispositif selon la revendication 1, **caractérisé en ce que** le dispositif de filtrage commutable (1) est un filtre en peigne.

3. Dispositif selon la revendication 2, **caractérisé en ce que** le filtre en peigne comprend, dans la direction du flux des signaux, soit p accumulateurs (7 ; 7, 70), un commutateur de décimation (8) et p différentiateurs (9), soit p accumulateurs (7 ; 7, 70), un commutateur de décimation (8) et (p -1) différentiateurs (9), le dernier accumulateur (70) dans la direction du flux de données étant ramené en arrière de manière simultanée avec la fermeture du commutateur de décimation (8) par le dispositif de commande (10), au moyen d'un dispositif de retour en arrière (72) et p étant supérieur ou égal à 1.

4. Dispositif selon l'une quelconque des revendications 1 à 3, **caractérisé en ce qu'**un dispositif de normalisation des amplitudes (4) compense la différente amplification du dispositif de filtrage commutable (1).

5. Dispositif selon l'une quelconque des revendications 1 à 4, **caractérisé en ce que** l'on envoie, indépendamment de l'état de commutation, un facteur d'affaiblissement fixe k au dispositif de normalisation des amplitudes (4).

6. Dispositif selon l'une quelconque des revendications 1 à 5, **caractérisé en ce que** le dispositif de commande (10) divise les n premières et les m deuxièmes valeurs de sortie sur une suite de données de sortie (d2) qui alterne de la manière la plus régulière possible.

EP 0 889 586 B1

Fig.1

Fig.2

Fig.3

Fig.4

EP 0 889 586 B1